(19) Europäisches Patentamt / European Patent Office / Office européen des brevets

(11) **EP 4 597 841 A1**

(12) **EUROPEAN PATENT APPLICATION**

(43) Date of publication:
**06.08.2025 Bulletin 2025/32**

(21) Application number: **24155116.7**

(22) Date of filing: **31.01.2024**

(51) International Patent Classification (IPC):
**H03K 17/16** (2006.01)   **H03K 17/14** (2006.01)
**H02M 1/08** (2006.01)   **H03K 17/28** (2006.01)

(52) Cooperative Patent Classification (CPC):
**H03K 17/162; H02M 1/08; H03K 17/14;**
**H03K 17/168; H03K 17/28**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ABB Schweiz AG**
**5400 Baden (CH)**

(72) Inventors:
- **Schalk, Martin**
  **5202 Neumarkt am Wallersee (AT)**
- **Holzner, Florian**
  **5231 Schalchen (AT)**
- **Maislinger, Franz**
  **5230 Mattighofen (AT)**
- **Vogel, Philipp**
  **9542 Münchwilen (CH)**

(74) Representative: **Patentanwälte Pinter & Weiss OG**
**Prinz-Eugen-Straße 70**
**1040 Wien (AT)**

(54) **GATE DRIVE CIRCUIT AND METHOD FOR SWITCHING A SEMICONDUCTOR SWITCH**

(57) A gate drive circuit (10) for switching a semiconductor switch (3) of an inverter (20) is provided, the gate drive circuit (10) comprising operating means (12) designed to alternate an electrical gate quantity ($U_{GE}$, $I_G$) between a maximum gate quantity value ($U_{GE,max}$, $I_{G,max}$) and a minimum gate quantity value ($U_{GE,min}$, $I_{G,min}$) in order to switch the semiconductor switch (3), the operating means (12) being further designed to, at an adjustment time point ($t_A$) during an operating interval ($T_{op}$), adjust said maximum gate quantity value ($U_{GE,max}$, $I_{G,max}$) to an adjusted maximum gate quantity value ($U_{max,A}$, $I_{max,A}$), to further alternate said electrical gate quantity ($U_{GE}$, $I_G$) between said adjusted maximum gate quantity value ($U_{GE,max,A}$, $I_{G,max,A}$) and said minimum gate quantity value ($U_{GE,min}$, $I_{G,min}$) to switch the semiconductor switch (3).

Fig. 1

EP 4 597 841 A1

Fig. 3

**Description**

The present invention pertains to a gate drive circuit for driving an electrical gate quantity present at a gate electrode of a semiconductor switch of an inverter, the gate drive circuit comprising operating means designed to, in a pre-defined operating interval, alternate said electrical gate quantity between a maximum gate quantity value and a minimum gate quantity value to switch the semiconductor switch in order to connect or disconnect a supply voltage to an output of the inverter. The invention further pertains to an assembly of an inverter, a cable and an electrical load, the inverter electrically connected to the electrical load by the cable in order to electrically supply the electrical load. Further, the invention pertains to a method for operating a gate drive circuit for driving an electrical gate quantity present at a gate electrode of a semi-conductor switch of an inverter.

In the design of modern power converters, much attention is paid to power conversion efficiency, power density, and system cost. Recently, also reliability of power electronic systems has been gaining increased attention, especially for systems with long operating hours in harsh environments.

Another aspect in today's power electronics to receive growing attention is the steady increase of switching frequencies. In this regard, significant progress has been made recently, bringing about new technologies, such as the so-called wide bandgap switches ("WBGs"), allowing for fast switching capabilities up to 10V/ns and higher, especially when compared to classical switching materials and/or classical switching technology. Unfortunately, high switching speeds are still accompanied by adverse effects, in the case of WBGs, but even more so in the case of "classical" semiconductors, such as classical insulated-gate bipolar transistors (IGBTs), classical metal-oxide-semiconductor field-effect transistor ("MOSFET"), etc. Said adverse effects range from voltage overshoot and/or voltage ringing between drain/emitter and source/collector of a switch, as well as to deteriorated electromagnetic interference properties (EMC).

These issues are known in the prior art, cf., US 2019 / 0074827 A1, US 11,316,513 B2 or GB 2589296 A. Also in scientific literature, issues related to high-speed switching of semiconductor switches, particularly IGBT-switches, have been covered at length.

"A four-step control for IGBT switching improvement using an active voltage gate driver", Chen Li et al., Wiley, IET Power Electronics, 2021, for instance, discloses a driving circuit and a corresponding method for switching an IGBT-switch, providing a step-wise modification of a gate-source voltage in the course of changing said gate-source voltage from a minimum to a maximum value for switching the IGBT, aiming at reduced overshoot of the gate-source voltage.

"A Voltage Controlled Current Source Gate Drive Method for IGBT Devices", Lu Shu et al., IEEE, 2014, discloses a similar concept, where different modification approaches for the gate-source voltage are suggested, depending on whether the gate-source voltage is changed from a minimum to a maximum value or vice versa.

Even though the above-referenced prior art discloses highly elaborate concepts targeted at improving the performance of semiconductor switches at high switching frequencies, it turns out that these concepts do not preserve their performance over the entire operating range.

Against this background, it is an object of the invention to provide an improved gate drive circuit with reduced losses, allowing for high consistency over the entire operating range of a switch or an inverter driven by the gate drive circuit. In the scope of the present invention, the term "gate drive circuit" is to be construed broadly, representing generally an electrical circuit capable of switching a semiconductor switch, e.g., BJTs or IGBTs or FETs, which are, e.g., known to have different pins (BCE, GCE, GDS, respectively).

This object, for the gate drive circuit mentioned at the outset, in accordance with independent claim 1, is achieved in that the operating means is further designed to, at an adjustment time point during the operating interval, adjust said maximum gate quantity value to an adjusted maximum gate quantity value, to further alternate said electrical gate quantity between said adjusted maximum gate quantity value and said minimum gate quantity value to switch the semiconductor switch.

By adjusting, i.e., reducing or increasing, the maximum gate quantity value, to which the electrical gate quantity is switched consecutively in order to switch, i.e., open and close, the semiconductor switch, the switching behavior of the power semiconductors is modified. Following up on the consideration laid out before, the maximum gate quantity value may be increased in order to speed up the switching process, or it may be reduced, in order to slow down the switching process. Consequently, a largely constant EMC emission spectrum can be achieved over the entire operating range of the inverter. Also, the switching losses are reduced with respect to specific operating points. E.g., when idling or at low output currents, oftentimes high capacitive motor cable currents can be reduced by switching the semiconductors on and off slowly. Fast switching edges, on the other hand, lead to lower switching losses at high operating currents. Thus, by adapting the switching edges during operation, the invention allows to consistently operate at an optimal setting regarding the switching speed used for switching the respective semiconductor switches.

Further, the above-mentioned object, for the assembly mentioned at the outset, is achieved in that the inverter present in the assembly comprises at least one semiconductor switch and a gate drive circuit according to the invention.

Further, the above-mentioned object, for the method mentioned at the outset, is achieved in that the method further comprises the steps of in a pre-defined operating interval during operation of the inverter, alternating said electrical gate quantity between a maximum gate quantity value and a minimum gate quantity value in order to switch the semiconductor switch, and at an adjustment time point during the operating interval, adjusting said maximum gate quantity value to an adjusted maximum gate quantity value.

Further, preferred embodiments of the gate drive circuit, the assembly, and the method, are subject of the dependent claims.

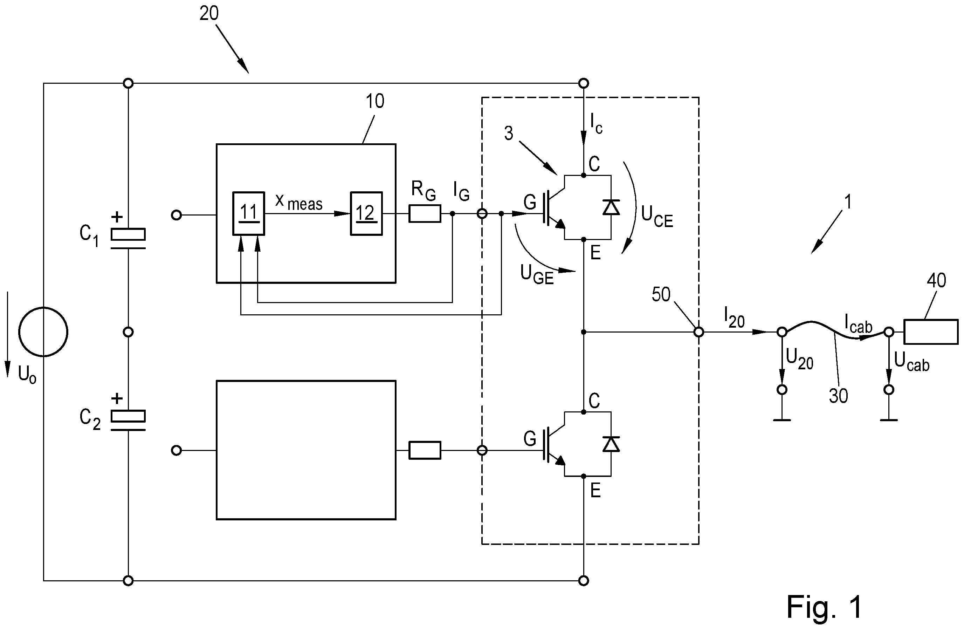

The present invention is described in greater detail below with reference to Figs. 1 to 6, which show schematic and non-limiting advantageous embodiments of the invention by way of example. The specific examples described herein are only used to explain the content of the present invention and are not intended to limit the present embodiment. The following are shown:

Fig.1 an arrangement of a gate driver circuit, an inverter, a cable, and an electrical load,

Figs. 2a, 2b possible profiles of the turn on behavior of an IGBT collector-emitter voltage,

Fig.3 possible signals occurring in the gate driver circuit according to the invention,

Fig.4 an implementation of the gate driver circuit according to the invention, based on a switched resistor,

Fig.5 an implementation of the gate driver circuit according to the invention, based on a push-pull converter,

Fig.6 an advantageous implementation of the gate driver circuit according to the invention employing feedback control.

Fig. 1 shows an arrangement of a gate driver circuit 10, an inverter 20 comprising two semi-conductor (power-)switches 3, a cable 30, an electrical load 40, an electrical source voltage Uo, and input capacitors $C_1$, $C_2$. Each semiconductor switch 3 has a gate electrode G, a collector electrode C, and an emitter electrode E. Such circuits and possible ways to operate such a circuit are known from the prior art, cf., e.g., US 9,444,448 B2.

The purpose of the gate drive circuit 10 is to drive an electrical gate quantity $U_{GE}$, $I_G$ present at a gate electrode G of the semiconductor switch 3 of the inverter 20, in order to switch the semiconductor switch 3 to eventually drive an electrical output current $I_{20}$ and/or an electrical output voltage $U_{20}$ of the inverter 20 through cable 30 to supply the load 40. To that end, the gate drive circuit 10 comprises operating means 12 designed to alternate said electrical gate quantity $U_{GE}$, $I_G$ between a maximum gate quantity value $U_{GE,max}$, $I_{G,max}$ and a minimum gate quantity value $U_{GE,min}$, $I_{G,min}$ to switch the semiconductor switch 3.

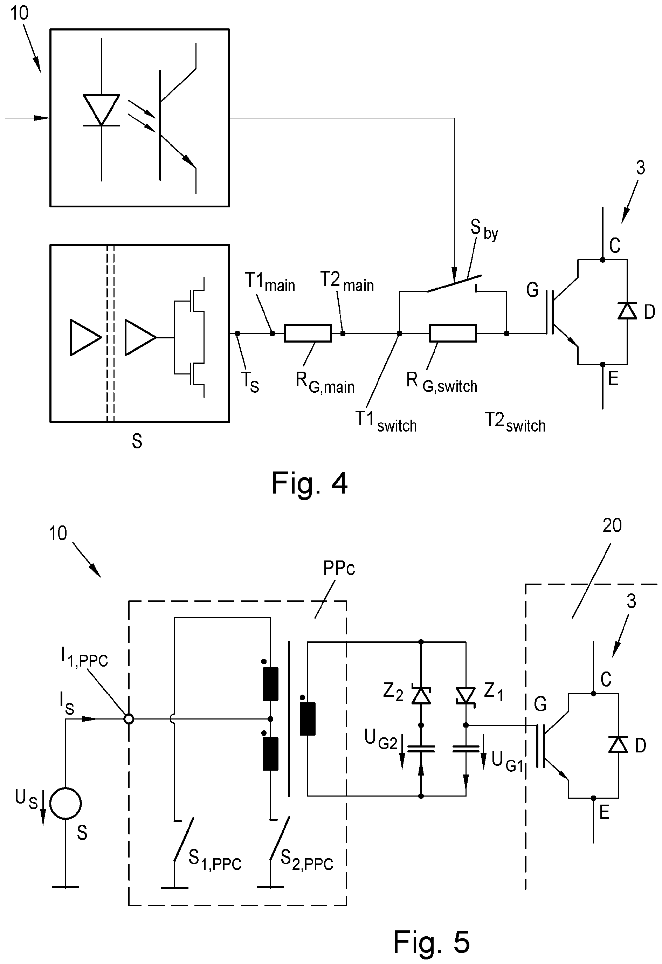

Said operating means 12 are well-known from the prior art as well, and may themselves comprise semiconductor switches and, e.g., a control unit, to provide one or more control signals for switching semiconductor switches 3 as those shown in Fig.1. Possible implementations of the gate drive circuit 10, operating means 12, etc. are discussed in detail later, wrt. Figs. 4 and 5. Hence, details regarding this aspect of the invention are omitted for now. As will be explained in detail later, too, within the scope of this invention, also the semiconductor switches 3 are by no means restricted to a specific kind of semiconductor switch, and may be implemented in the form of an insulated-gate bipolar transistor IGBT, a bipolar junction transistor BJT, or a field-effect transistor FET.

Preferably, said electrical gate quantity $U_{GE}$, $I_G$ is an electrical voltage dropping from said gate electrode G to said emitter electrode E, or an electrical current flowing to or from the gate electrode G. By alternating the electrical gate quantity $U_{GE}$, $I_G$ between a maximum gate quantity value $U_{GE,max}$, $I_{G,max}$ and a minimum gate quantity value $U_{GE,min}$, $I_{G,min}$ (positive gate emitter voltages are typically applied to switch on a switch 3, while negative gate emitter voltages are applied to switch it off), several well-known operating methods, such as pulse-width modulation (PWM), pulse-frequency modulation (PFM), etc., may be implemented, with the aim of generating a pulsed electrical output current $I_{20}$ and/or a pulsed electrical output voltage $U_{20}$ having a pre-defined current-time-area or voltage-time-area in a pre-defined time interval, respectively. As the fundamentals of operating an electric circuit like the one shown in Fig. 1, especially with regards to implementing methods as PWM, PFM etc., are well-known in the prior art, e.g., from US 2019 / 0074827 A1, US 11,316,513 B2 or GB 2589296 A, further details in this respect are spared at this point.

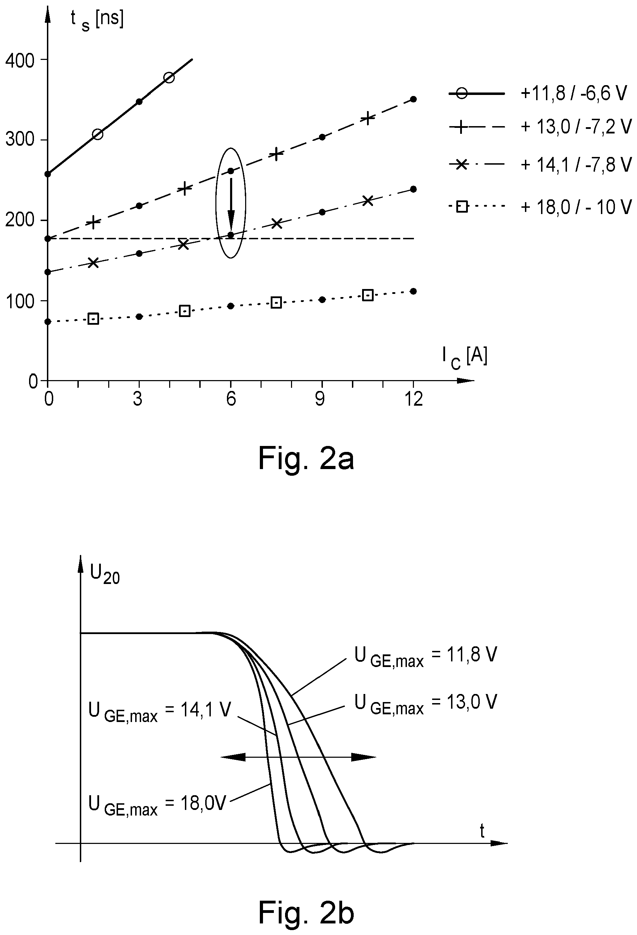

In the course of the invention, it was found that certain physical quantities, most importantly the aforementioned electrical gate quantities, i.e., gate-emitter voltage $U_{GE}$ and/or gate current $I_G$ and especially their maximum values used for switching the respective semiconductor switches 3, have a crucial impact on the performance metrics of a gate drive circuit 10, such as (power) losses, EMC, dynamical and transient behavior of output quantities like $U_{20}$ and/or $I_{20}$, etc., as will be explained in the following, on the basis of Figs. 2a and 2b

To that end, Fig. 2a first presents possible switching times ts of a semiconductor switch 3, in the case shown the switching times of an IGBT, as a function of the collector current Ic. It was found that the time ts it takes to switch the semiconductor switch 3, i.e., to complete the transition from entirely closed to entirely open, varies with the collector current $I_C$ drawn from the semiconductor switch 3. Varying switching times $t_S$, however, are problematic, for several reasons. On the one hand, large switching times and thus slow switching, for obvious reasons, increases switching losses, already because the switching processes takes longer, leading to longer periods of time where both the current flowing through the switch as well as the voltage dropping over the switch are unequal zero. On the other hand, small switching times and thus high switching speeds lead to fast changes of the involved electrical quantities, leading to increased electromechanical radiation and thus worsened EMC properties. It is thus important to select an optimized switching time ts for a given application, taking into account the benefits and drawbacks of an increased or reduced switching time, and maintain this switching time throughout operation.

Fig.2b, on the contrary, shows time profiles of an output voltage $U_{20}$ produced by an inverter 20 as shown in Fig. 1, for different maximum values of the gate-emitter voltage $U_{GE}$. With a higher voltage, the gate charge required to switch the semiconductor switch 3, in this case an IGBT, is applied more quickly, thus reducing the switching time ts. For the switching process, it can thus be stated that switching times ts can be reduced when larger gate-emitter voltages $U_{GE}$ are being employed.

Combining the findings presented in Figs.2a and 2b, one may conclude that a change in switching speed due to a changed collector current $I_C$ may be compensated by adjusting the gate supply and hence the gate-emitter voltages $U_{GE}$. An increase in switching times at higher operating currents Ic can hence be compensated for by adjusting $U_{GE}$, in order to maintain an optimized switching time ts.

In the prior art, however, especially when it comes to switching IGBT switches, permanent gate-emitter voltages with constant maximum magnitude are typically employed. Due to the fixed gate emitter voltage, the switching behavior of the IGBT modules can only be defined for a single specific operating point, leading to the aforementioned disadvantages in case of dynamic load profiles, e.g., voltage ringing between drain and source of a power semiconductor switch, increased losses, and deteriorated electromagnetic interference (EMI) properties.

To overcome these drawbacks and to provide a gate drive circuit 10 that allows for higher consistency over the operating range of an inverter 20 driven by the gate drive circuit 10, according to the invention, the operating means 12 is further designed to, at an adjustment time point $t_A$ in a pre-defined operating interval $T_{op}$ during operation of the inverter 20, adjust said maximum gate quantity value $U_{GE,max}$, $I_{G,max}$ to an adjusted maximum gate quantity value $U_{max,A}$, $I_{max,A}$, to further alternate said electrical gate quantity $U_{GE}$, $I_G$ between said adjusted maximum gate quantity value $U_{max,A}$, $I_{max,A}$ and said minimum gate quantity value $U_{GE,min}$, $I_{G,min}$ to switch the semiconductor switch 3. The operating interval $T_{op}$ may, e.g., be an interval selected by a user or in another fashion, in which a modification of the maximum gate quantity value $U_{max,A}$, $I_{max,A}$ according to the invention may be allowed. In case a modification of the maximum gate quantity value $U_{max,A}$, $I_{max,A}$ shall be allowed any time during operation, the pre-defined operating interval $T_{op}$ may simply of course also correspond to the on-time of the inverter 20. Also, more than one operating interval $T_{op}$ may be provided during operation, so as to allow a modification during certain, selected time segments, e.g., only during low-load conditions or only during high-load conditions etc. Also the length of an operating interval $T_{op}$ may of course be varied, from just a few, e.g. 10 or 50 or 100, sampling intervals, thus having a length less than a second, to more extended periods of time, e.g. having a length of several minutes or hours etc.

By adjusting, i.e., reducing or increasing, the maximum gate quantity value $U_{max,A}$, $I_{max,A}$, to which the electrical gate quantity $U_{GE}$, $I_G$ is switched consecutively in order to switch, i.e., open and close, the semiconductor switch 3, the switching behavior of the power semiconductors 3 is modified. Following up on the consideration laid out before, the maximum gate quantity value $U_{max,A}$, $I_{max,A}$ may be increased in order to speed up the switching process, or it may be reduced, in order to slow down the switching process. Consequently, a largely constant EMC emission spectrum can be achieved over the entire operating range of the inverter 20. Also, the switching losses are reduced with respect to specific operating points. E.g., when idling or at low output currents, oftentimes high capacitive motor cable currents can be reduced by switching the semiconductors on and off slowly. Fast switching edges, on the other hand, lead to lower switching losses at high operating currents. Thus, by adapting the switching edges during operation, the invention allows to consistently operate at an optimal setting regarding the switching speed used for switching the respective semiconductor switches 3.

As mentioned previously, the adjusted maximum gate quantity value $U_{max,A}$, $I_{max,A}$ may be smaller, e.g. 10% smaller, or 20% smaller, or 50% smaller, than the maximum gate quantity value $U_{GE,max}$, $I_{G,max}$, or the adjusted maximum gate quantity value $U_{max,A}$, $I_{max,A}$ may as well be larger, e.g. 10% larger or 20% larger or 50% larger or 100% larger, than the maximum gate quantity value $U_{GE,max}$, $I_{G,max}$, depending on whether the maximum gate quantity value $U_{GE,max}$, $I_{G,max}$ needs to be increased or decreased, in order to conserve an optimized switching time ts.

In a particularly advantageous embodiment of the invention, the gate drive circuit 10 may further comprise detecting means 11 for, at at least one detection time point $t_D$ during the operating interval $T_{op}$, detecting at least one measured value $x_{meas,D}$ of a physical inverter quantity x representative of an operating condition assumed by the inverter 20 during the operating interval $T_{op}$. Such detecting means 11 may, e.g., be implemented in the form of a current sensor or a voltage sensor or a temperature sensor or a hall sensor, depending on the physical quantity to be measured, preferably connected with appropriate signal processing devices. Preferably, such signal processing devices may be implemented in the form of microprocessor-based hardware, such as microcontrollers and/or integrated circuits (ASIC, FPGA).

In case a detecting means 11 is provided, the adjustment time point $t_A$ may be selected as an adjustment time point $t_A$ during the operating interval $T_{op}$ after the detection time point $t_D$. Using the at least one measured value $x_{meas,D}$, the operating means may be designed to, at the adjustment time point $t_A$, adjust said maximum gate quantity value $U_{GE,max}$, $I_{G,max}$ to the adjusted maximum gate quantity value $U_{max,A}$, $I_{max,A}$ depending on the at least one measured value $x_{meas,D}$ of the physical inverter quantity x.

Taking into account said measured value $x_{meas,D}$, it so becomes possible to, e.g., monitor a collector current by measuring the collector current measured value $x_{meas,D}$, define a rated current, e.g. 5A or 10A or 15A or 50A or 100A, and reduce the maximum gate quantity value $U_{max,A}$, $I_{max,A}$, in case collector current underpasses, e.g., 5% or 10% or 20% or 35% or 50% of the rated current. The measured value $x_{meas,D}$ may also correspond to a temperature of the inverter, where a temperature threshold may be defined and the maximum gate quantity value $U_{max,A}$, $I_{max,A}$ may be modified in case this threshold is underrun or surpassed, or, as in the case described above, a percentage value of such a temperature threshold is underrun or surpassed. Also, a load condition may be monitored by means of the measured value $x_{meas,D}$, or a parameter describing losses occurring in the inverter 20, which can again be a temperature, e.g., a temperature of a semiconductor switch 3, or a temperature of a housing of a semiconductor switch 3. Due to this flexibility, the invention allows for a dynamic adaptation of the switching behavior of semiconductor switch 3, taking into account especially those quantities, that are important in a given application.

Specifically, in this embodiment of the invention, the physical inverter quantity x may be selected from the group consisting of a gate or collector current $I_G$, a gate or collector current time differential $dI_G/dt$, a gate-emitter or a collector-emitter voltage $U_{GE}$, a gate-emitter or a collector-emitter voltage time differential $dU_{GE}/dt$ in said semiconductor switch 3, a component temperature of a component of the inverter 20, and an electrical power processed by the inverter 20 during the operating interval $T_{op}$.

In case of the assembly 1 shown in Fig.1, comprising an inverter 20, a power cable 30 and an electrical load 40, the inverter 20 being electrically connected to the electrical load 40 by the power cable 30 in order to electrically supply the electrical load 40, and the inverter 20 comprising at least one semiconductor switch 3 and a gate drive circuit 100 according to the invention, the detecting means, in a particularly advantageous manner, may be further designed to detect an electrical cable quantity $U_{cab}$, $I_{cab}$ of said power cable 30 as the at least one measured value $x_{meas}$. The detecting means thereby may further be designed to identify at least one cable parameter from the least one measured value $x_{meas}$, the cable parameter being representative of said operating condition assumed by the inverter 20 during the operating interval $T_{op}$, and the operating means may be designed to adjust said maximum gate quantity value $U_{GE,max}$, $I_{G,max}$ dependent on the at least one cable parameter. Therein, the at least one cable parameter may be selected from the group consisting of a cable length, a cable resistance, a cable inductance, a cable material, a cable cross section, a cable diameter, a cable capacity.

To identify said at least one cable parameter, the gate drive circuit 10 may advantageously be designed to set the electrical gate quantity $U_{GE}$, $I_G$ to an identification gate quantity value $U_{GE,I}$, $I_{G,I}$ generating an identification output voltage on the output 50 of the inverter 20 to be fed to the cable 30 at an excitation time point $t_E$, measure at least one measured value $x_{meas}$ of at least one electrical cable quantity $x_{cable}$, at at least one detection time point $t_D$ after the identification time point $t_I$, and, identify at least one cable parameter $Z_{cab}$ of the cable 30 from the least one measured value $x_{meas}$ and the identification gate quantity value $U_{GE,I}$, $I_{G,I}$ at an identification time point ti after the detection time point $t_D$.

In this preferred embodiment, the at least one cable parameter $Z_{cab}$ may be selected from the group consisting of a cable length, a cable resistance, a cable inductance, a cable material, a cable cross section, a cable diameter, a cable capacity, and in that the at least one cable quantity $x_{cable}$ may be selected from the group consisting of a cable current $I_{cable}$, a cable voltage $U_{cable}$, a cable temperature $T_{cable}$, a cable magnetic field $B_{cable}$.

With this kind of cable identification method, it specifically becomes possible to employ an electrical gate quantity for identification purposes, which has not yet been done before. In this respect, it may further be provided to, at a multiple of, preferably consecutive, excitation time points $t_{E,1}$, $t_{E,2}$,..., set the electrical gate quantity $U_{GE}$, $I_G$ to a corresponding identification gate quantity values $U_{GE,I,1}$, $U_{GE,1,1}$,... at each of said excitation time points $t_{E,1}$, $t_{E,2}$,..., to measure a multiple of measured values $x_{meas}$ of the at least one electrical cable quantity $x_{cable}$ at a multiple of detection time points $t_{D,1}$, $t_{D,2}$,... corresponding to said multiple of excitation time points $t_{E,1}$, $t_{E,2}$,..., and to identify the at least one cable parameter $Z_{cab}$ of the cable 30 from the multiple of measured values $x_{meas}$ and the multiple of identification gate quantity values $U_{GE,I}$, $I_{G,I}$.

However, it is to be pointed out that measuring and taking into account a physical quantity representative of an operating condition assumed by the inverter 20 during the operating interval $T_{op}$ is not mandatory. On the contrary, the adjustment time point $t_A$ and the adjusted maximum gate quantity value $U_{max,A}$, $I_{max,A}$ may as well be pre-set before a start of operation of the inverter 20. For example, it may be known in advance that after a pre-described time between the start of operation of the inverter 20 and the adjustment time point $t_A$, a low-load condition will be assumed, such that a reduction of the maximum gate quantity value $U_{max,A}$, $I_{max,A}$ is to be carried out.

Of course, in case of adjusting the maximum gate quantity value $U_{GE,max}$, $I_{G,max}$ depending on said measured value $x_{meas}$, the maximum gate quantity value $U_{GE,max}$, $I_{G,max}$ may preferably be pre-set before a start of operation of the inverter 20 and adjusted to said adjusted maximum gate quantity value $U_{max,A}$, $I_{max,A}$ during operation of the inverter 20 at the adjustment time point $t_A$.

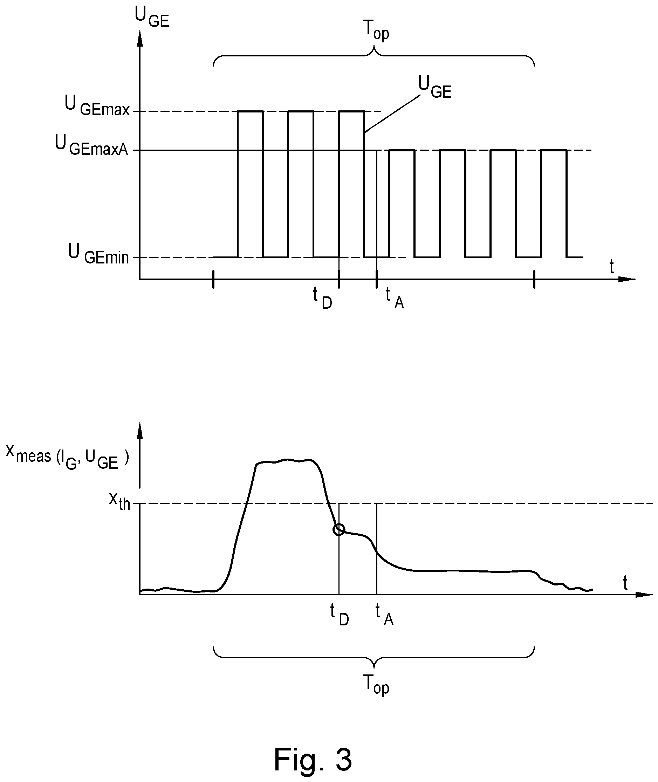

Fig.3 further shows signals as they may occur during operation of a gate driver circuit 10 according to the invention. Specifically, in the case shown in Fig.3, operation is started at time point to, after which the measured quantity $x_{meas}$ is increased sharply, for which a first, high maximum gate quantity value $U_{GE,max}$, $I_{G,max}$ is used for alternating the electrical gate quantity $U_{GE}$, $I_G$ to switch the semiconductor switch 3. At the detection time point $t_D$, however, a measured value $x_{meas,D}$ of a physical inverter quantity x, which can be a current, or a temperature, or a voltage, etc., representative of an operating condition assumed by the inverter 20 during the operating interval $T_{op}$ is detected. It is found that the measured value $x_{meas,D}$ lays below a pre-set threshold value $x_{th}$, leading to a reduction of the maximum gate quantity value $U_{GE,max}$, $I_{G,max}$ to the smaller adjusted maximum gate quantity value $U_{max,A}$, $I_{max,A}$ at the adjustment time point $t_A$. As is well-known from digital signal processing, measuring measured values $x_{meas,D}$ may of course as well be carried on more than just one detection time point $t_D$, but preferably at a multiple number of detection time points $t_{D,k}$ which may be derived from a time discretization, preferably an equidistant time discretization, where detection time points $t_{D,k}$ are distanced by a pre-described sampling time $T_d$. In this fashion, a multiple of measured values may be consecutively compared to a pre-described threshold value, in order to immediately react to potential changes in the operation condition of the inverter 20.

As mentioned earlier, specific implementations of a gate drive circuit according to the invention are shown in Figs.4 and 5.

Specifically, Fig.4 shows an implementation of the gate driver according to the invention, based on a switched resistor $R_{G,switch}$. In the implementation according to Fig.4, an electrical supply unit S to supply said gate electrode G with an electrical supply quantity Us, Is to create said electrical gate quantity $U_{GE}$, $I_G$, a main gate resistor $R_{G,main}$, at least one switchable gate resistor $R_{G,switch}$, and a bypass switch $S_{by}$ are provided. The supply unit S is electrically connected to the main gate resistor $R_{G,main}$ by an electrical connection between a supply unit output terminal $T_s$ and a first main gate resistor terminal $T1_{,main}$, the at least one switchable gate resistor $R_{G,switch}$ is connected in series to the main gate resistor $R_{G,main}$ by an electrical connection between a first switchable gate resistor terminal $T1_{,switch}$ and a second main gate resistor terminal $T2_{,main}$, the bypass switch $S_{by}$ is connected in parallel to the at least one switchable gate resistor $R_{G,switch}$, and the at least one switchable gate resistor $R_{G,switch}$ is electrically connected to said gate electrode G by a second switchable gate resistor terminal $T2_{,switch}$.

In this setup, the operating means 12 is designed to switch the bypass switch $S_{by}$, hence bypassing the at least one switchable gate resistor $R_{G,switch}$, in order to adjust said maximum gate quantity value $U_{GE,max}$, $I_{G,max}$ to said adjusted maximum gate quantity value $U_{max,A}$, $I_{max,A}$

The advantage of this implementation is that the switching speed can be changed quickly, i.e. high dynamics are possible without having to forego precise control of the gate supply voltage.

Fig.5, on the contrary, presents an implementation of the gate driver according to the invention based on a push-pull converter PPC. Specifically, in the implementation according to Fig.5, an electrical supply unit S to supply said gate electrode G with an electrical supply quantity Us, Is to create said electrical gate quantity $U_{GE}$, $I_G$ and a push-pull converter PPC are provided in the gate drive circuit 10. The push-pull converter PPC in this case is electrically connected to the supply unit S by an electrical connection between a supply unit output terminal $T_S$ and a first push-pull converter terminal $T1_{,PPC}$, the at least one push-pull converter PPC is electrically connected to said gate electrode G via a second push-pull converter terminal $T2_{,PPC}$. In the case of Fig.5, the operating means is designed to switch at least one switch $S_{1,PPC}$, in the case off Fig.5 the two switches $S_{1,PPC}$ and $S_{2,PPC}$, of the push-pull converter PPC to adjust said maximum gate quantity value $U_{GE,max}$, $I_{G,max}$ to said adjusted maximum gate quantity value $U_{max,A}$, $I_{max,A}$

Symmetrical control of the two switches $S_{1,PPC}$ and $S_{2,PPC}$ converts the primary DC voltage $U_S$ into an AC voltage and transfers it to the secondary side. The rectification on the secondary side further allows to generate two gate voltages $U_{G1}$ and $U_{G2}$ with different signs, whereby the amplitude is determined by the transformer's turns ratio. The potential-free gate voltages on the secondary side of the transformer $U_{G1}$ and $U_{G2}$ are directly proportional to the primary input voltage $U_{IN}$:

$$U_{G1} \sim \frac{U_{IN}}{\ddot{u}_1} - U_D = \frac{U_{IN}}{N1/N3} - U_D$$

$$U_{G2} \sim -\left(\frac{U_{IN}}{\ddot{u}_2} - U_D\right) = -\left(\frac{U_{IN}}{N2/N3} - U_D\right)$$

By changing the primary input voltage Us, it becomes possible to adjust the resulting gate voltage for controlling the semiconductor switch 3 (IGBT or FET) without any further hardware effort. This implementation has the advantage that no hardware adjustments are necessary for adapting the maximum gate quantity value $U_{GE,max}$, $I_{G,max}$, which is beneficial especially in use-cases with high operating voltages. This also means that no additional costs occur, e.g., for further isolated signal transmissions to adapt the switching behavior in the hardware design.

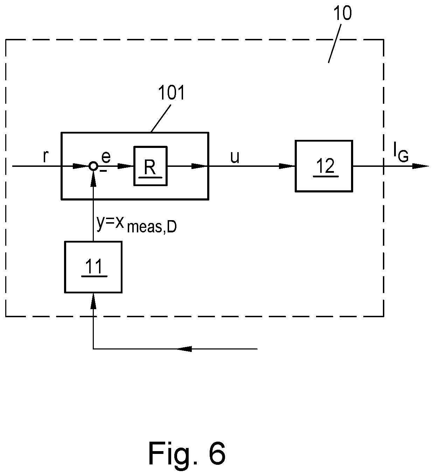

A further advantageous implementation of the gate driver circuit according to the invention is depicted in Fig.6. In Fig.6, additionally a control unit 101 is provided in the gate drive circuit 10, the control unit 101 being designed to accept said measured value $x_{meas,D}$ of the physical inverter quantity x as a control feedback signal y, compute a control signal u from the measured value $x_{meas}$, and feed said control signal u to the operating means, in order for the operating means to adjust said maximum gate quantity value $U_{GE,max}$, $I_{G,max}$ according to the control signal u.

As the signal processing devices, also the control unit 101 may be implemented in the form of microprocessor-based hardware, such as microcontrollers and/or integrated circuits (ASIC, FPGA). In a particularly advantageous embodiment of the implementation with a control unit 101 from Fig.6, said control unit 101 may be designed to consecutively accept measured values $x_{meas,D}$ detected in the operating interval $T_{op}$, preferably at the aforementioned equidistant detection time points $t_{D,k}$, as a control feedback signal y and continuously compute said control signal u from the control feedback signal y in accordance with a pre-defined control law R implemented in the control unit 101.

Specifically, said control law R may be configured to compute a control error e by comparing said feedback signal y with a pre-defined set point value r, the pre-defined set point value r corresponding to a desired operating condition of the inverter 20, and to compute said control signal u from the control error e in accordance with the control law R, the control law R preferably being selected from the group consisting of a PID-controller, an MPC-controller, a flatness-based controller, a sliding-mode controller or even an neuronal network based controller.

**Claims**

1. A gate drive circuit (10) for driving an electrical gate quantity ($U_{GE}$, $I_G$) present at a gate electrode (G) of a semiconductor switch (3) of an inverter (20), the gate drive circuit (10) comprising operating means (12) designed to, in a pre-defined operating interval ($T_{op}$) during operation of the inverter (20), alternate said electrical gate quantity ($U_{GE}$, $I_G$) between a maximum gate quantity value ($U_{GE,max}$, $I_{G,max}$) and a minimum gate quantity value ($U_{GE,min}$, $I_{G,min}$) to switch the semiconductor switch (3) in order to connect or disconnect a supply voltage ($U_o$) to an output (50) of the inverter (20), **characterized in that** the operating means (12) is further designed to, at an adjustment time point ($t_A$) during the operating interval ($T_{op}$), adjust said maximum gate quantity value ($U_{GE,max}$, $I_{G,max}$) to an adjusted maximum gate quantity value ($U_{max,A}$, $I_{max,A}$), to further alternate said electrical gate quantity ($U_{GE}$, $I_G$) between said adjusted maximum gate quantity value ($U_{max,A}$, $I_{max,A}$) and said minimum gate quantity value ($U_{GE,min}$, $I_{G,min}$) to switch the semiconductor switch (3).

2. The gate drive circuit (10) according to claim 1, **characterized in that** the gate drive circuit (10) further comprises detecting means for, at at least one detection time point ($t_D$) during the operating interval ($T_{op}$), detecting at least one measured value ($x_{meas,D}$) of a physical inverter quantity (x) representative of an operating condition assumed by the inverter (20) during the operating interval ($T_{op}$), **in that** the adjustment time point ($t_A$) is provided as an adjustment time point ($t_A$) during the operating interval ($T_{op}$) after the detection time point ($t_D$), **and in that** the operating means is designed to, at the adjustment time point ($t_A$), adjust said maximum gate quantity value ($U_{GE,max}$, $I_{G,max}$) to the adjusted maximum gate quantity value ($U_{max,A}$, $I_{max,A}$) depending on the at least one measured value ($x_{meas,D}$) of the physical inverter quantity (x).

3. The gate drive circuit (10) according to any one of claims 1 to 2, **characterized in that** the maximum gate quantity value ($U_{GE,max}$, $I_{G,max}$) is pre-set before a start of operation of the inverter (20) and adjusted to said adjusted maximum gate quantity value ($U_{max,A}$, $I_{max,A}$) during operation of the inverter (20) at the adjustment time point ($t_A$).

4. The gate drive circuit (10) according to any one of claims 1 to 3, **characterized in that** the adjusted maximum gate quantity value ($U_{max,A}$, $I_{max,A}$) is smaller than the maximum gate quantity value ($U_{GE,max}$, $I_{G,max}$) **or in that** the adjusted maximum gate quantity value ($U_{max,A}$, $I_{max,A}$) is larger than the maximum gate quantity value ($U_{GE,max}$, $I_{G,max}$).

5. The gate drive circuit (10) according to any one of claims 1 to 4, **characterized in that** an electrical supply unit (S) to supply said gate electrode (G) with an electrical supply quantity ($U_s$, $I_S$) to create said electrical gate quantity ($U_{GE}$, $I_G$), a main gate resistor ($R_{G,,main}$), at least one switchable gate resistor ($R_{G,switch}$), and a bypass switch ($S_{by}$) are provided in the gate drive circuit (10), the supply unit (S) electrically connected to the main gate resistor ($R_{G,main}$) by an electrical connection between a supply unit output terminal (Ts) and a first main gate resistor terminal ($T1_{,main}$), the at least one switchable gate resistor ($R_{G,switch}$) connected in series to the main gate resistor ($R_{G,main}$) by an electrical connection between a first switchable gate resistor terminal

(T1$_{,switch}$) and a second main gate resistor terminal (T2$_{,main}$), the bypass switch (S$_{by}$) connected in parallel to the at least one switchable gate resistor (R$_{G,switch}$), the at least one switchable gate resistor (R$_{G,switch}$) electrically connected to said gate electrode (G) by a second switchable gate resistor terminal (T$_{2,switch}$), **and in that** the operating means is designed to switch the bypass switch (S$_{by}$), hence bypassing the at least one switchable gate resistor (R$_{G,switch}$), in order to adjust said maximum gate quantity value (U$_{GE,max}$, I$_{G,max}$) to said adjusted maximum gate quantity value (U$_{max,A}$, I$_{max,A}$).

6. The gate drive circuit (10) according to any one of claims 1 to 4, **characterized in that** an electrical supply unit (S) to supply said gate electrode (G) with an electrical supply quantity (Us, Is) to create said electrical gate quantity (U$_{GE}$, I$_G$) and a push-pull converter (PPC) are provided in the gate drive circuit (10), the push-pull converter (PPC) electrically connected to the supply unit (S) by an electrical connection between a supply unit output terminal (Ts) and a first push-pull converter terminal (T1$_{,PPC}$), the at least one push-pull converter (PPC) electrically connected to said gate electrode (G) via a second push-pull converter terminal (T2$_{,PPC}$), **and in that** the operating means is designed to switch at least one switch (S1$_{,PPC}$) of the push-pull converter (PPC) to adjust said maximum gate quantity value (U$_{GE,max}$, I$_{G,max}$) to said adjusted maximum gate quantity value (U$_{max,A}$, I$_{max,A}$).

7. The gate drive circuit (10) according to any one of the preceding claims 2 to 6, **characterized in that** a control unit (101) is provided in the gate drive circuit (10), the control unit (101) being designed to accept said measured value (x$_{meas,D}$) of the physical inverter quantity (x) as a control feedback signal (y), compute a control signal (u) from the measured value (x$_{meas}$), and feed said control signal (u) to the operating means, in order for the operating means to adjust said maximum gate quantity value (U$_{GE,max}$, I$_{G,max}$) according to the control signal (u).

8. The gate drive circuit (10) according to claim 7, **characterized in that** said control unit (101) is designed to continuously accept measured values (x$_{meas,D}$) detected in the operating interval (T$_{op}$), preferably at equidistant detection time points (t$_{D,k}$), as a control feedback signal (y) and continuously compute said control signal (u) from the control feedback signal (y) in accordance with a pre-defined control law (R) implemented in the control unit (101).

9. The gate drive circuit (10) according to claim 8, **characterized in that** said control law (R) is configured to compute a control error (e) by comparing said feedback signal (y) with a pre-defined set point value (r), the pre-defined set point value (r) corresponding to a desired operating condition of the inverter (20), and to compute said control signal (u) from the control error (e) in accordance with the control law (R), the control law (R) preferably being selected from the group consisting of a PID-controller, an MPC-controller, a flatness-based controller, a sliding-mode controller or a neuronal network based controller.

10. The gate drive circuit (10) according to any one of the preceding claims 2 to 9, **characterized in that** the physical inverter quantity (x) is selected from the group consisting of a gate or collector current (I$_G$), a gate or collector current time differential (dIc/dt), a gate-emitter or a collector-emitter voltage (U$_{GE}$), a gate-emitter or a collector-emitter voltage time differential (dU$_{GE}$/dt) in said semiconductor switch (3), a component temperature of a component of the inverter (20), and an electrical power processed by the inverter (20) during the operating interval (T$_{op}$).

11. The gate drive circuit (10) according to any one of the preceding claims, **characterized in that** said operating means, in order to adjust said maximum value maximum gate quantity value (U$_{GE,max}$, I$_{G,max}$), is designed to modify at least one value selected from the group consisting of a gate resistance (R$_G$), a gate power supply voltage, a gate current, a gate-emitter capacitance and a gate-emitter capacitance.

12. The gate drive circuit (10) according to claim 1, **characterized in that** the adjustment time point (t$_A$) and the adjusted maximum gate quantity value (U$_{max,A}$, I$_{max,A}$) are pre-set before a start of operation of the inverter (20).

13. Assembly (1) comprising an inverter (20), a power cable (30) and an electrical load (40), an output (50) of the inverter (20) being electrically connected to the electrical load (40) by the power cable (30) in order to electrically supply the electrical load (40), and the inverter (20) comprising at least one semiconductor switch (3) and a gate drive circuit (10) according to any one of the preceding claims.

14. Assembly (1) according to claim 13, **characterized in that** the detecting means is designed to detect an electrical cable quantity (U$_{cab}$, I$_{cab}$) of said power cable (30) as the at least one measured value (x$_{meas}$), **in that** the detecting means is further designed to identify at least one cable parameter from the least one measured value (x$_{meas}$), the cable parameter being representative of said operating condition assumed by the inverter (20) during the operating interval (T$_{op}$), **and in that** the operating means is designed to adjust said maximum gate quantity value (U$_{GE,max}$, I$_{G,max}$) dependent on the at least one cable parameter.

**15.** A method for operating a gate drive circuit (10) for driving an electrical gate quantity ($U_{GE}$, $I_G$) present at a gate electrode (G) of a semiconductor switch (3) of an inverter (20), comprising the steps of

- in a pre-defined operating interval ($T_{op}$) during operation of the inverter (20), alternating said electrical gate quantity ($U_{GE}$, $I_G$) between a maximum gate quantity value ($U_{GE,max}$, $I_{G,max}$) and a minimum gate quantity value ($U_{GE,min}$, $I_{G,min}$) in order to switch the semiconductor switch (3),

- at an adjustment time point ($t_A$) during the operating interval ($T_{op}$), adjusting said maximum gate quantity value ($U_{GE,max}$, $I_{G,max}$) to an adjusted maximum gate quantity value ($U_{max,A}$, $I_{max,A}$).

Fig. 1

Fig. 2a

Fig. 2b

Fig. 3

**Fig. 4**

**Fig. 5**

Fig. 6

# EUROPEAN SEARCH REPORT

**Application Number**

EP 24 15 5116

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/179196 A1 (YAMAMOTO SHOTARO [JP] ET AL) 8 June 2023 (2023-06-08) | 1-4,7,8, 10,11, 13,15 | INV. H03K17/16 H03K17/14 |
| A | * paragraph [0102]; figures 1, 2, 7, 8 * * paragraph [0110] * * paragraph [0113] - paragraph [0118] * * paragraph [0090] * | 5,6,9 | H02M1/08 H03K17/28 |
| | ----- | | |
| X | US 2022/416782 A1 (AKIYAMA HIRONORI [JP] ET AL) 29 December 2022 (2022-12-29) | 1-5, 7-11,13, 15 | |
| A | * figures 5,6,7 * | 6 | |
| | ----- | | |
| X | US 10 790 818 B1 (FRANK WOLFGANG [DE]) 29 September 2020 (2020-09-29) | 1-4,6-8, 10,11, 13,15 | |
| A | * figures 2, 3B * | 5,9 | |
| | ----- | | |
| A | US 9 350 341 B2 (FAIRCHILD KR SEMICONDUCTOR LTD [KR] ET AL.) 24 May 2016 (2016-05-24) * figure 2 * | 1-11,13, 15 | |
| | ----- | | **TECHNICAL FIELDS SEARCHED (IPC)** H03K H02M |

The present search report has been drawn up for all claims

| Place of search | Date of completion of the search | Examiner |
|---|---|---|
| The Hague | 19 June 2024 | Fermentel, Thomas |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

Europäisches
Patentamt

European
Patent Office

Office européen
des brevets

**Application Number**

EP 24 15 5116

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-11, 13, 15

☐ The present supplementary European search report has been drawn up for those parts of the European patent application which relate to the invention first mentioned in the claims (Rule 164 (1) EPC).

17

Europäisches
Patentamt
European
Patent Office
Office européen
des brevets

**LACK OF UNITY OF INVENTION**
**SHEET B**

Application Number

EP 24 15 5116

The Search Division considers that the present European patent application does not comply with the requirements of unity of invention and relates to several inventions or groups of inventions, namely:

    1. claims: 1-11, 13, 15

        Gate drive circuit

    1.1. claims: 1-5, 7, 8, 10, 11, 13, 15

        Gate drive circuit comprising a switchable gate resistor
        connected in series to a main gate resistor

    1.2. claim: 6

        Gate drive circuit comprising a push-pull converter, PPC, to
        adjust a maximum gate quantity value

    1.3. claim: 9

        Gate drive circuit configured to computate a control signal
        from a control error a the pre-defined set point value
                ---

    2. claim: 12

        Gate drive circuit with pre-set adjustment time point and
        adjusted maximum gate quantity value
                ---

    3. claim: 14

        Gate drive circuit with detection of a cable parameter and
        adjustment of a maximum gate quantity value dependent on the
        at least one cable parameter.
                ---

Please note that all inventions mentioned under item 1, although not
necessarily linked by a common inventive concept, could be searched
without effort justifying an additional fee.

## ANNEX TO THE EUROPEAN SEARCH REPORT
## ON EUROPEAN PATENT APPLICATION NO.

EP 24 15 5116

This annex lists the patent family members relating to the patent documents cited in the above-mentioned European search report.
The members are as contained in the European Patent Office EDP file on
The European Patent Office is in no way liable for these particulars which are merely given for the purpose of information.

19-06-2024

| Patent document cited in search report | Publication date | Patent family member(s) | Publication date |
|---|---|---|---|
| US 2023179196 A1 | 08-06-2023 | CN 115668724 A | 31-01-2023 |
| | | DE 112020007274 T5 | 11-05-2023 |
| | | JP 7325632 B2 | 14-08-2023 |
| | | JP WO2021245719 A1 | 09-12-2021 |
| | | US 2023179196 A1 | 08-06-2023 |
| | | WO 2021245719 A1 | 09-12-2021 |
| US 2022416782 A1 | 29-12-2022 | CN 115244838 A | 25-10-2022 |
| | | JP 7180626 B2 | 30-11-2022 |
| | | JP 2021141661 A | 16-09-2021 |
| | | US 2022416782 A1 | 29-12-2022 |
| | | WO 2021177098 A1 | 10-09-2021 |
| US 10790818 B1 | 29-09-2020 | CN 112583389 A | 30-03-2021 |
| | | EP 3799308 A1 | 31-03-2021 |
| | | US 10790818 B1 | 29-09-2020 |
| US 9350341 B2 | 24-05-2016 | KR 20140147903 A | 31-12-2014 |
| | | US 2014368254 A1 | 18-12-2014 |

EPO FORM P0459

For more details about this annex : see Official Journal of the European Patent Office, No. 12/82

## REFERENCES CITED IN THE DESCRIPTION

**Patent documents cited in the description**

- US 20190074827 A1
- US 11316513 B2
- GB 2589296 A
- US 9444448 B2

**Non-patent literature cited in the description**

- A four-step control for IGBT switching improvement using an active voltage gate driver. **CHEN LI et al.** IET Power Electronics. Wiley, 2021
- **LU SHU et al.** A Voltage Controlled Current Source Gate Drive Method for IGBT Devices. IEEE, 2014